# EUROPEAN PATENT SPECIFICATION

(11) **EP 2 973 755 B1**
(45) Date of publication and mention of the grant of the patent: **05.12.2018**
(21) Application number: 14713593.3
(22) Date of filing: 10.03.2014
(51) Int. Cl.: H01L 33/16, H01L 33/42, H01L 33/40, H01L 33/20, H01L 33/22

(54) **SEMICONDUCTOR STRUCTURE COMPRISING A POROUS REFLECTIVE CONTACT**
HALBLEITERSTRUKTUR MIT EINEM PORÖSEN REFLEKTIVEN KONTAKT
STRUCTURE SEMICONDUCTEUR COMPRENANT UN CONTACT RÉFLÉCHISSANT POREUX

(30) Priority: 13.03.2013 US 201361779410 P
(43) Date of publication of application: 20.01.2016
(73) Proprietor: Lumileds Holding B.V., 1118 BG Schiphol (NL)
(72) Inventor: EPLER, John Edward, NL-5656 AE Eindhoven (NL)
(74) Representative: Rüber, Bernhard Jakob
(86) International application number: PCT/IB2014/059572
(87) International publication number: WO 2014/141028

(56) References cited:
- WO-A1-2011/052395
- US-A1- 2005 161 696
- US-A1- 2007 284 607
- US-A1- 2010 019 260
- US-A1- 2012 032 214

## Description

### Field of the invention

The invention relates to a semiconductor light emitting device, such as a light emitting diode which includes a porous semiconductor region.

### Background

Semiconductor light-emitting devices including light emitting diodes (LEDs), resonant cavity light emitting diodes (RCLEDs), vertical cavity laser diodes (VCSELs), and edge emitting lasers are among the most efficient light sources currently available. Materials systems currently of interest in the manufacture of high-brightness light emitting devices capable of operation across the visible spectrum include Group III-V semiconductors, particularly binary, ternary, and quaternary alloys of gallium, aluminum, indium, and nitrogen, also referred to as III-nitride materials. Typically, III-nitride light emitting devices are fabricated by epitaxially growing a stack of semiconductor layers of different compositions and dopant concentrations on a sapphire, silicon carbide, III-nitride, or other suitable substrate by metal-organic chemical vapor deposition (MOCVD), molecular beam epitaxy (MBE), or other epitaxial techniques. The stack often includes one or more n-type layers doped with, for example, Si, formed over the substrate, one or more light emitting layers in an active region formed over the N-type region or layers, and one or more P-type regions doped with, for example, Mg, formed over the active region. Electrical contacts are formed on the N- and P-type regions. Often, an N-type region is deposited on the substrate, then an active region is deposited on the N-type region, then a P-type region is deposited on the active region. The order of the layers may be reversed such that the P-type region is adjacent to the substrate although that practice is not common.

LEDs are non-ideal devices that contain many optical loss mechanisms, both within the semiconductor layers, such as active region re-absorption and free-carrier absorption, and at semiconductor-metal interfaces where highly-reflective effective Ohmic contacts are difficult to realize. Light rays trapped by total internal reflection or waveguiding are particularly impacted by these mechanisms.

An LED will typically have a light emitting surface as the "top" of the LED. The surface opposite the top surface is described to as the "bottom" of the LED. For efficient light extraction, optical loss of the large area bottom reflector must be minimized. The bottom reflector in many LED designs is also an electrical contact which limits the choice of materials which may be used as a reflector. Additionally, an efficient LED must contain some design element to enhance the extraction of light from the high refractive index semiconductor stack into the low refractive index encapsulant and then into air. At a planar interface between high and low index materials only rays lying within the escape cone will pass through, higher angle rays being reflected back into the chip. Unless these higher angle rays are redirected by scattering they will "waveguide" within the chip and be absorbed with a high probability. If the semiconductor stack is thick enough relative to the LED width, say a ratio of at least 0.3:1 height to width, the light rays may be guided to escape through the "top" and/or sides of the LED by optimizing the sidewall angle of the chip. To achieve a "tall" transparent device structure, the epitaxial layers may be grown on transparent substrates or alternatively they may be grown on an absorbing substrate which is removed and then the epitaxial layers are bonded to transparent window substrates with a semiconductor-to-semiconductor process. An example of this design element formed by the second method is the well-known truncated inverted pyramid (TIP) AlInGaP LEDs commercially available from Philips Lumileds Lighting. A second design element is a roughening or patterning of the top surface. Light rays in the semiconductor that strike a non-planar interface have a greater chance to escape. Also the photons scattered back into the semiconductor are with high probability redirected which reduces waveguiding. A third design element is a scattering layer buried inside the semiconductor. The function of this layer is primarily to randomize the photon direction and reduce waveguiding. Since scattering results in some reflection, having a scattering level beneath the active region is particularly effective. If the scattering layer may be built into the bottom reflector it may be especially effective. In that case some improvement in reflectivity is expected and the scattering effect will limit waveguiding and enhance extraction.

A porous semiconductor is an effective optical scattering layer that may be incorporated into the semiconductor stack. The material is nearly lossless and highly scattering because of the large index difference between air and semiconductor and the large interfacial area. Porous GaP regions have been combined with AuGe contacts for AlInGaP LEDs as described in U.S. Patent No. 8,174,025. But there is a need to further improve this type of contact. US 2005/0161696 discloses a semiconductor light-emitting device formed by stacking a plurality of semiconductor layers including an active layer, wherein at least a portion of a semiconductor layer of the plurality of semiconductor layers is made porous. The semiconductor layer made porous has a surface serving as a light-extraction surface for extracting light emitted from the active layer. In order to prevent direct exposure to atmosphere, the porous light extraction surface may be covered by a protection film, in particular an ITO film. US 2007/0284607 A1 discloses a light emitting device including a semiconductor structure having a light emitting layer disposed between an n-type region and a p-type region. A porous region is disposed between the light emitting layer and a contact electrically connected to one of the n-type region and the p-type region. The porous region scatters light away from the absorbing contact. WO 2011/052395 A1 discloses a semiconductor structure comprising a semiconductor crystal (an n-type semiconductor layer, a light emitting layer and a p-type semiconductor layer), a contact layer and p- and n-side electrodes. The contact layer may comprise ITO. The surface of the semiconductor crystal, in particular the surface of the p-type semiconductor layer has a fine irregular structure.

### Summary

In accordance with the invention a light emitting device includes a semiconductor structure having a light emitting region disposed between an N-type region and a P-type region. Contacts are electrically connected to the N-type and the P-type region. At least one contact is comprising an ITO region and a metallic region. A porous region is disposed between the light emitting region and the contact comprising an ITO region and a metallic region . The ITO region of the first contact is disposed between the first porous region and the metallic region of the first contact. The light emitting region is disposed between the first porous region and the surface from which a substantial fraction of the light extracted from the semiconductor structure is emitted. The ITO mitigates diffusion of metals into the porous region. The ITO and metal contact serve as the reflector and the porous region serve as a scattering region. In some embodiments the porous region is an N-type semiconductor material such as GaN or GaP.

As discussed in U.S. Patent No. 8,174,025 the use of a porous layer is effective in enhancing the efficiency of AlInGaP LEDs when combined with an alloyed contact. Increased lm/W is observed but there may be difficulties in controlling the contact formation process because the porosity of the GaP material enables a rapid diffusion of Au and Ge into the semiconductor during creation of an alloyed contact. Too much diffusion increases optical losses from the incorporated Au and Ge, and insufficient diffusion results in an increase in forward voltage from an under-alloyed contact. Furthermore the poor reflectivity of the AuGe alloy requires a thick porous layer of at least 10µm to sufficiently reduce optical losses, i.e. the porous layer must be of sufficient thickness that greater than 90% of the light doesn't reach the contact. There may also be a small yet significant reduction of the electrical and thermal conductivity of this thick porous layer. There is a need to further improve this type of contact by avoiding an alloyed contact and avoiding light absorbing contact metals such as AuGe. With a non-alloyed contact and higher reflectivity materials, a much thinner porous layer may be used and a more robust process realized.

The semiconductor contact may be a transparent conductive oxide such as Indium Tin Oxide (ITO), or Indium Zinc Oxide (IZO) and the high reflectivity materials may be Silver or Gold. An adhesion promoting layer such as of Titanium or Nickel may be interposed between the transparent conductive oxide and reflective metal. Adhesion promoting layers may be as thin as 5 nm. One proposed contact utilizes an Indium Tin Oxide (ITO) region and a silver region in combination with a porous region to create a more reflective contact with a more robust process flow. In the alternative a Titanium Silver region may be combined with the porous region.

The use of an ITO contact has been disclosed in US patent No. 7,985,979. ITO contacts have also been employed commercially i.e. Epistar HB-ITO LEDs. In accordance with an embodiment of the invention the aforementioned porous region in a device wafer may be coated with an ITO layer to form an Ohmic contact to the semiconductor. It was observed that the annealing temperature and time required to form the Ohmic contact with the ITO material does not result in substantial alloying and in-diffusion of contact materials into the semiconductor layer, therefore the transparency of the semiconductor and ITO-are not compromised.

ITO may be combined with a metal to form an Ohmic contact with good reflective properties. The contact may be reflective to the light emitted by the light emitting region. In one embodiment a thick porous region may be used as a diffuse reflector and the ITO and metal contact mitigates diffusion of metals into the porous region during annealing. According to the invention the ITO and metal contact may serve as the reflector and a somewhat thinner porous region may serve as a scattering region. Any suitable tradeoff between scattering and reflectivity is contemplated and is included within the scope of the invention.

The porous region may be thick enough to provide scattering, at about 3-5 um. An ITO/Ag contact may be made to the N-type region in an AlInGaP device. An analogous structure may be used for a large area n-GaN reflective, scattering contact.

Porosity may be controlled by the current density during the porous etch. Higher current densities create a more porous structure. Optically the more porous the layer is, the greater the scattering and hence, the thinner the layer that's needed to achieve a given cumulative scattering. A 10% porous (volume etched away) with an 8 micron thickness may be as effective as a 30% porous layer only 4 micron thick. The index of refraction of the original non-porous layer is another factor in scattering power. The porous layer is optically a mixture of the non-porous original material and air with the scattering deriving from the difference between the index of refraction, n, of the semiconductor and air. Given equal porosities, a porous layer of higher index materials such GaP (n∼3.3) will have a higher scattering power than a porous layer of GaN (n∼2.4). For a given application and porosity, a thicker layer of GaN would be required. The porous layer may be regarded as having a single value of n, resulting from a weighted average of the indices of refraction of the original layer and air (n∼1). The design of the porous layer should consider the optical effect of the final stack of materials such as original non-porous semiconductor, porous semiconductor, ITO, and Ag. For example, the reflectivity of the combined structure may be optimized by selecting the thickness and porosity of the porous layer.

The porous process may be patterned (restricted to certain areas) by dielectric layers such as silicon nitride. Areas of the surface covered by a dielectric material will not be made porous. The surface need not be flat. Prior to the porosity creating process, a structure may be etched into the semiconductor or created by other means such as growth on a non-planar substrate which is subsequently removed.

The porous region is typically created at the wafer level by applying an electrical contact to the wafer and submerging the wafer in a corrosive bath with an electrical bias. In some cases illumination of the wafer may be used to enhance the process. Generally during the wafer processing, the growth substrate is removed, the semiconductor may be etched to reveal a specific region such as the N-type semiconductor contact region that is then made porous. The thickness and porosity are controlled with time and current density to provide adequate light scattering but without causing a significant decrease in thermal and electrical conduction through the porous region. After creation of porous region an ITO/Ag contact is formed. A version with a P-type porous region and an ITO/Ag contact is also contemplated and is included within the scope of the invention. A version with a P-type porous region and an ITO/Ag contact is also contemplated and is included within the scope of the invention. A version with patterned porous region(s) and an ITO/Ag contact is also contemplated and is included within the scope of the invention. Another embodiment is to grow an InGaN LED structure on a transparent, conducting bulk GaN substrate, render a portion of the P-type region porous, process the ITO/Ag contact, process the backside of the substrate with a patterned n-contact, and then saw the crystal with a beveled blade to create an angled sidewall. A similar embodiment suitable for a bulk GaN or SiC growth substrate is contemplated where in place of a backside contact; a flip chip process is used to place both contacts on the epitaxy side of the wafer. The sidewall would be created with the beveledsaw.

### Brief description of the drawings

In the drawings:
Figs. 1a-k shows a side view of the steps of creating an LED with a reflective contact;
Fig. 2 shows a side view of an LED with a reflective contact using a shaped device;
Fig. 3a-g shows a side view of the steps of creating an LED with a reflective contact;
Fig. 4a-e shows a side view of the steps of creating an LED with a reflective contact; and
Fig 5 shows a side view of a flip chip LED with a reflective contact using a shaped device.

Use of the same reference numbers in different figures indicates similar or identical elements.

### Detailed description

Although a square die shape is described any suitable die shape or shapes are contemplated and are included within the scope of the invention.

Although a substrate with epitaxial layers is shown, other semiconductor constructions utilizing non-epitaxial layers e.g. amorphous layers, are contemplated and are included within the scope of the invention. Although a wafer with epitaxial layers and a substrate are shown, other configurations such as a wafer of devices mounted or bonded to a wafer of submounts are contemplated and are included within the scope of the invention.

Although the exemplary embodiments show an AlInGaP or InGaN LED any suitable LED configuration is contemplated and included within the scope of the invention. Though the devices described in the examples below generally include III-phosphide semiconductor layers grown on a GaAs substrate, in some embodiments III-nitride semiconductor layers may be used.

Although in some cases a vertical thin film (VTF) LED is shown as being formed other constructions such as a thin film flip chip (TFFC) or a non-thin film flip chip (FC) where both the P-contact on top and N-contact are on one side of the device (the bottom of the device). In other embodiments a modified vertical thin film(VTF) device is contemplated and included withing the scope of the invention.

In accordance with embodiments of the invention, a semiconductor light emitting device includes a reflective contact which includes a reflective region and/or a scattering/reflective region, such as a porous semiconductor region. The reflective region redirects light from the bottom surface of the LED towards the top surface of the LED. The scattering/reflective region randomizes the direction of photons emitted from the device. Typically the combination of the reflective region and the scattering/reflective region act as a diffuse reflector that scatters light toward desired emitting surfaces of the device, such as the top surface of the device, where a majority of light extracted from the device may be emitted.

The scattering region comprises a porous semiconductor formed from a non-porous semiconductor such as GaP or other III-P layer, GaN, or GaAs. The porous region is generally electrically and thermally conducting. The porous region may be formed from an N-type region, and after being made porous, the N-type porous region may be converted to P-type conductivity, or the porous region may be formed directly from a P-type region. Typically the porous region is arranged as a uniform layer. As previously described, the amount of scattering is determined by the thickness and porosity of the porous region. The porous region generally has a thickness between 0.4 and 40 microns. The porous region may have a porosity between 5% and 80% and often has a porosity between 20% and 40%. The porosity is limited on the lower end by the ability of the porous region to scatter light and on the upper end by the resistivity and mechanical stability of the porous region. As previously described, suitable porosity may be related to the type of semiconductor, the thickness of the porous region and optical effects pertaining the anticipated stack of materials.

Although the descriptions refer to "regions" of material, material other more specific configurations may be formed such as a region configured into a layer, a portion of a layer. Each of these arrangements of regions or any other suitable configuration of material are contemplated and are included within the scope of the invention. Layers may also be formed by creating a layer that is uneven and is then smoothed to be level (flat) or masked to remove portions of the layer.

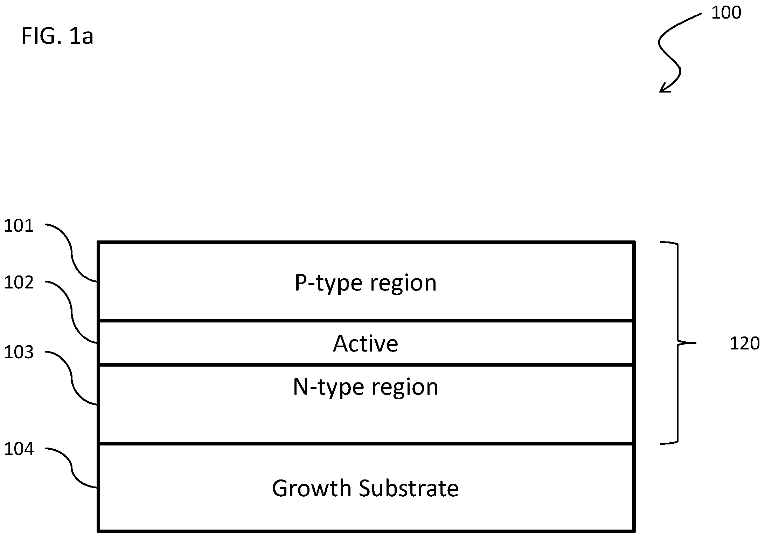

Figs 1a-1k shows an exemplary method for creating a device. Although the steps of the method shown here may be used to produce an AlInGaP VTF device, any other suitable device type that may be constructed using this method is contemplated and is included within the scope of the invention. Although the steps of the process are shown in a particular order other variations such as changing the point in the process when annealing takes place are contemplated and are included within the scope of the invention.

Fig. 1a is a side view of an exemplary portion of a wafer of LEDs 100. Wafer 100 may be created by growing an AlInGaP epitaxial layer 120 on a growth substrate 104. Epitaxial layer 120 may contain an active region 102 between an N-type region 103 and a P-type region 101. P-type region 101 may be transparent to a wavelength of light emitted by active region 102.

Although Figs. 1a-1k show the N-type region 103 connected to growth substrate 104, other configurations that reverse the order of the layers such that the P-type region is connected to the substrate are contemplated and are included within the scope of the invention.

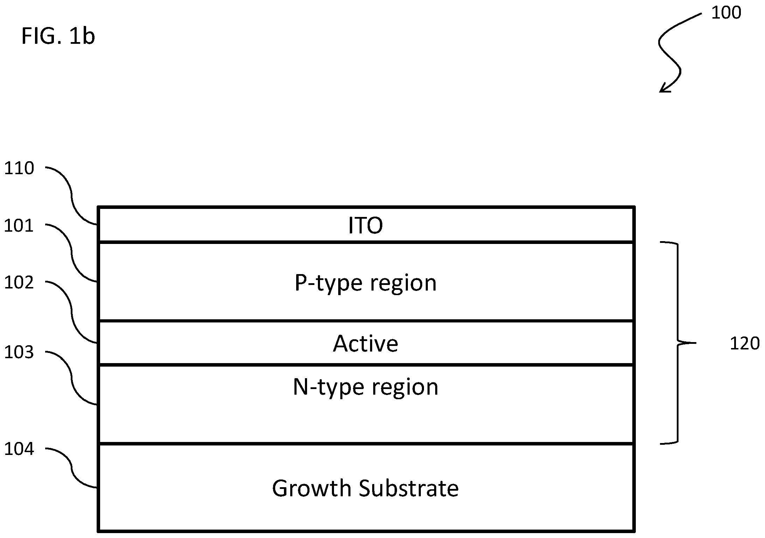

Fig. 1b shows wafer 100 after an ITO region 110 is formed on P-type region 101. Typically ITO region 110 is formed via an evaporative process and/or a sputtering process. Preferably ITO region 110 is transparent to the light emitted form active region 102. Although ITO is specified any suitable substitute is contemplated and is included within the scope of the invention.

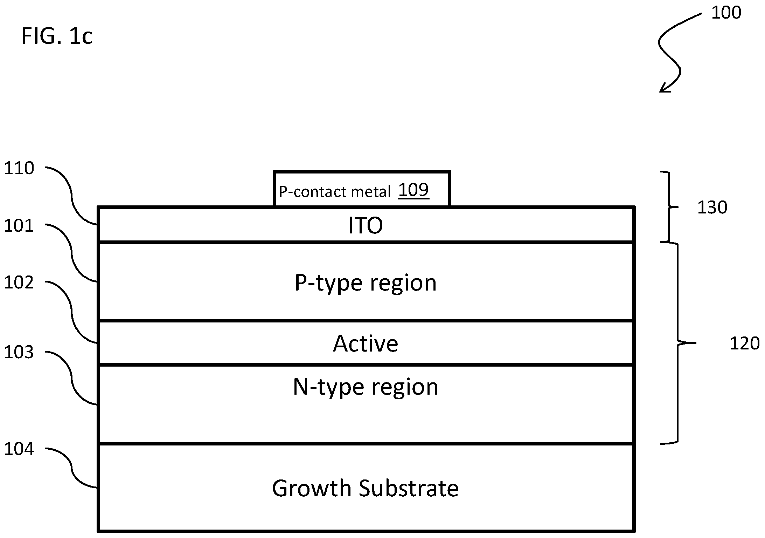

Fig. 1c shows wafer 100 after a P-contact metal 109 is created on ITO region 110. P-contact metal together with ITO region 110 forms a P-contact 130. Typically a resist is patterned to expose a portion of ITO region 110 followed a coating of Titanium and Silver (TiAg) and a lift-off step to create the P-contact metal 109. P-contact metal 109 may be formed as a thin layer of Titanium followed by a thicker layer of Silver. As described above Titanium may sever as an adhesion layer. In the alternative alloys of Ti and Ag or multiple layers in any order may be used as P-contact metal 109. As described above other metals such as Nickel may be used as the adhesion layer.

P contact 109 may be smaller to minimize blocking of light emitted from active region 102 through P-type region 101. Although a single P-contact metal 109 is shown, multiple P-contact metals of any suitable shape and configuration are contemplated and are included within the scope of the invention. For some process flows, the P-contact metal will be subjected to temperatures in excess of 400 C° and stable metals such as Silver and Gold (Au) are preferred. Although TiAg is specified, Chromium/Gold (Cr/Au)Titanium/Gold (TiAu) or any other suitable combination/alloy or metal/organic combination is contemplated and is included within the scope of the invention.

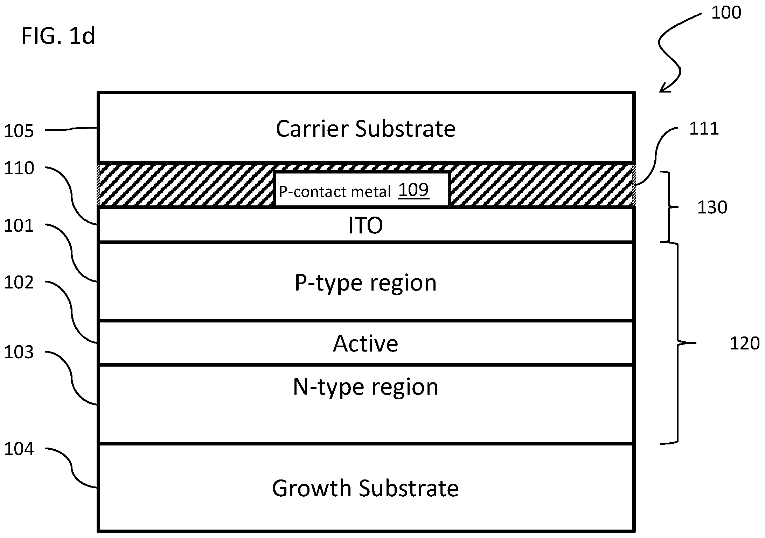

Fig. 1d shows wafer 100 after attaching a carrier substrate 105 to P-contact metal 109 and ITO region 110. Typically the carrier substrate 105 is attached with a high temperature organic bonding material 111. An organic bonding material 111 is forgiving of uneven surface features such as the P-contact metal 109. The carrier substrate 105 provides stiffness to epitaxial layer 120 during the remaining processing of wafer 100.

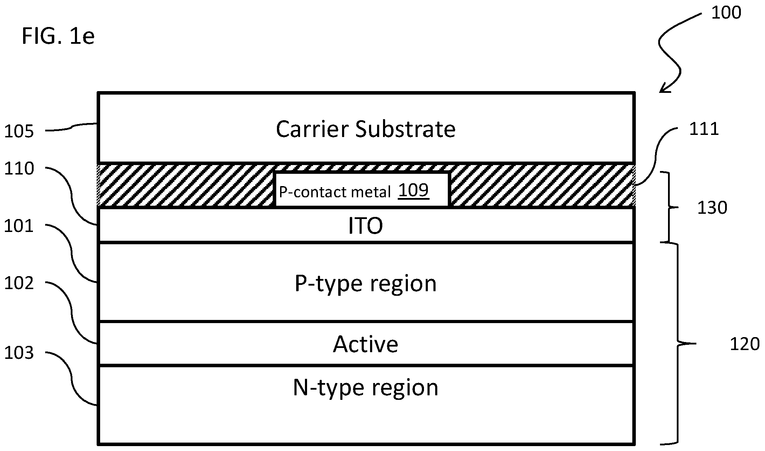

Fig. 1e shows wafer 100 after removal of growth substrate 104 from epitaxial layer 120. Typically growth substrate 104 is removed by first grinding and and/or lapping to remove the bulk of the material and then etching to remove the last part of the material.

Fig. If shows wafer 100 after a portion of N-type region 103 has been converted into porous region 103A. Converting any amount of N-type region 103 to a porous region 103A including a small portion or all of N-type region 103 is contemplated and is included within the scope of the invention. N-type region 103 may be converted in a layer as shown in Fig. If or in lateral sections (not shown) where some lateral sections of N-type region 103 remain unconverted. Likewise the porous region 103A may vary in thickness so that some sections are thick and others are thinner.

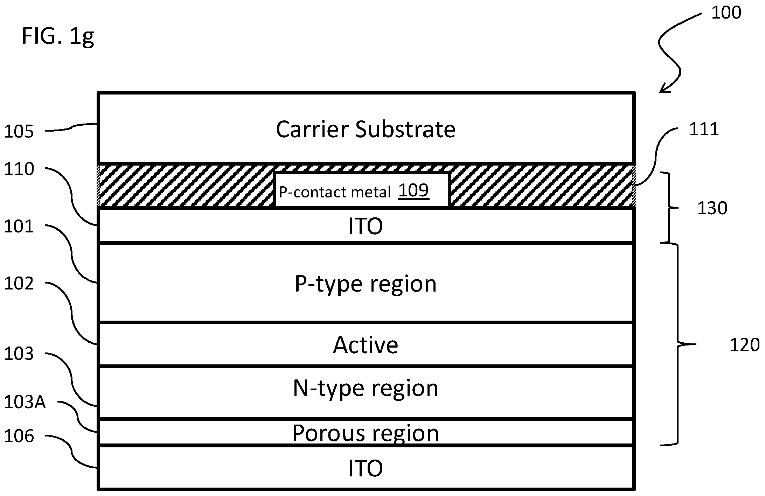

Fig. 1g shows wafer 100 after an ITO region 106 is formed on the porous region 103A. Typically ITO region 106 is formed via an evaporative process and/or a sputtering process. Although ITO is specified any suitable substitute is contemplated and is included within the scope of the invention.

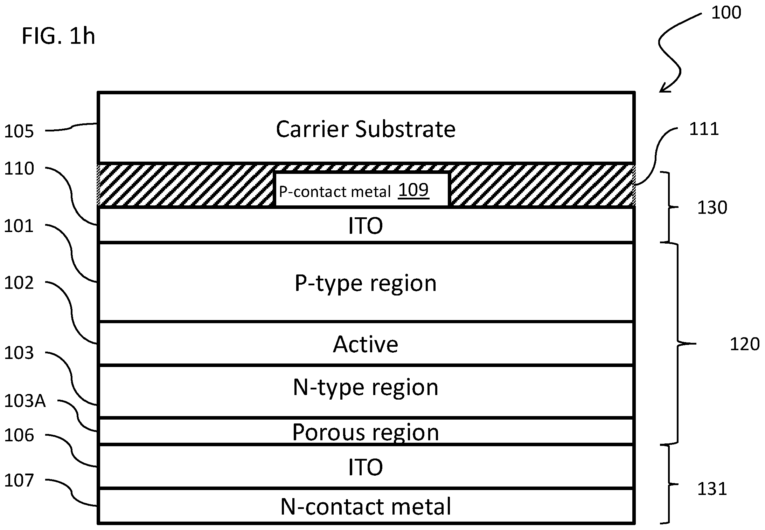

Fig. 1h shows wafer 100 after N-contact metal 107 is created on ITO region 106 to complete the formation of N-contact 131. Patterned N-contact metal may be formed by removing photoresist from some portion of ITO region 106 followed a coating of TiAg and a lift-off step. Although TiAg is specified, TiAu, CrAu or any other suitable combination/alloy or metal/organic combination is contemplated and is included within the scope of the invention. 107 may be formed over some or all of ITO region 106. N-contact metals formed of multiple regions, lateral sections and portions that bypass ITO region 106 are contemplated and are included within the scope of the invention. As described above with respect to the P-contact 130 Ti may be formed as an adhesion layer. In the alternative, alloys of Ti and Ag or multiple layers in any order may be used as P-contact metal 109.

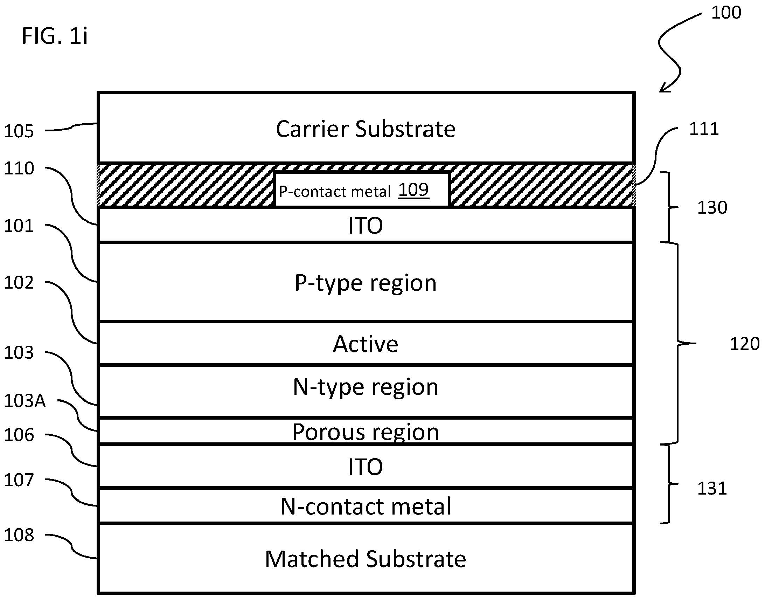

Fig. 1i shows wafer 100 after a matched substrate 108 is bonded to N-contact metal 107. Matched substrate 108 may be an Aluminum Silicon (AlSi) or Germanium (Ge) substrate. Typically matched substrate 108 is metal bonded to the N-contact metal 107. Au-Au thermocompression bonding or Pd-In eutectic bonding are two possible methods compatible with temperature limits of organic bonding material 111. Matched substrate 108 provides structural support and matches the thermal expansion of the growth substrate 104 and/or epitaxial layer 120.

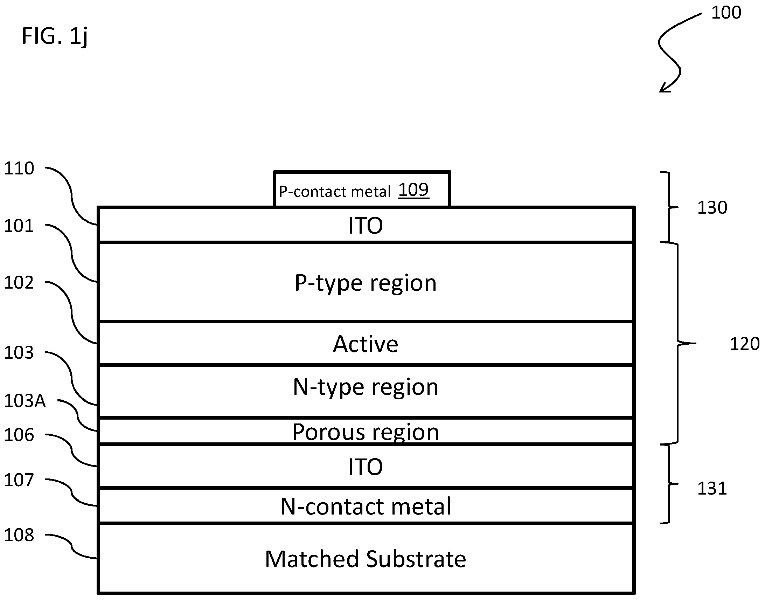

Fig. 1j shows wafer 100 after removal of carrier substrate 105 and annealing of the contacts. Carrier substrate 105 may be removed by breaking the temporary bond of the carrier substrate 105 to P-contact metal 109 and ITO region 110. The temporary bond may be organic and broken by elevated temperature of approximately 200 C°.

The annealing process completes the mechanical and electrical connection between both contacts; between P-contact metal 109, ITO region 110 and P-type region 101 and between N-contact metal 107, ITO region 106 and porous region 103A. Various annealing recipes may be used although lower temperatures require a longer annealing time. For example a 400 C° anneal for 25 minutes or a 700 C° anneal for one minute may suffice. The annealing temperature should be kept within the acceptable range for the chosen contact metals. Additionally, the annealing may be accompanied by pressure to improve the strength of the bond to the matched substrate.

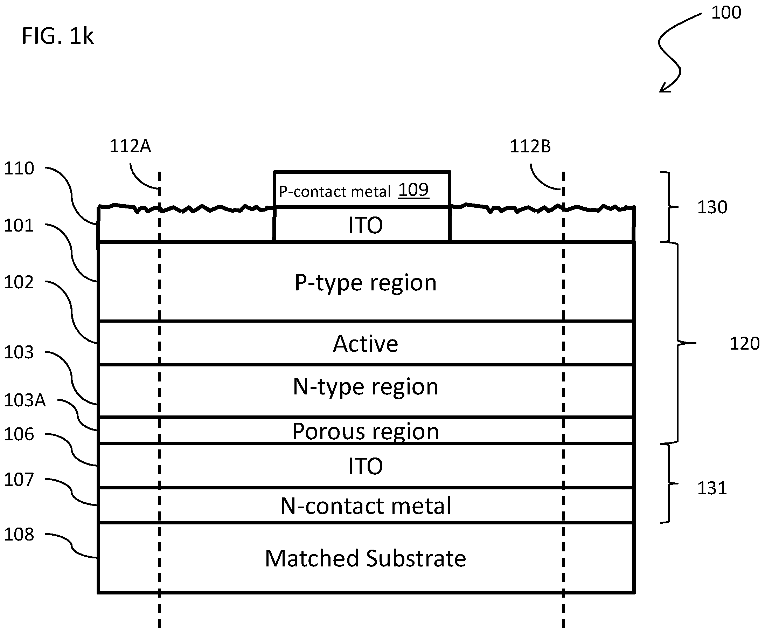

Fig. 1k shows wafer 100 after roughening some or all of the exposed surface of ITO region 110. Wafer 100 may be singulated into individual devices along singulation lines 112A and 112B.

In the alternative a roughened layer is grown on the exposed surface of ITO region 110. In yet another alternative embodiment photoresist is patterned to leave some areas of the surface of ITO region 110 exposed and through the openings ITO region 110 is etched, even down to the P-type region 101. Likewise after removing portions of ITO region 110, portions of P-type region 101 may be etched or roughened.

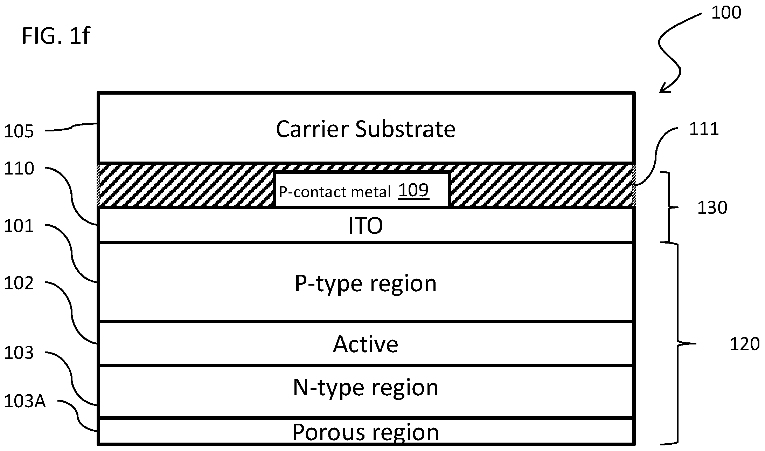

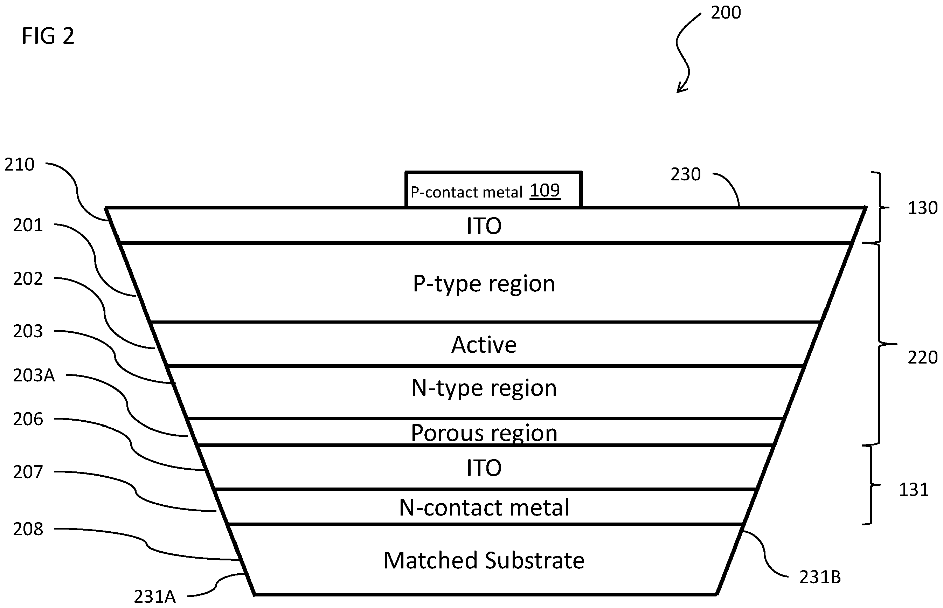

Fig. 2 shows an embodiment of the invention with a similar process flow as Fig. 1 but having non-vertical sidewalls. The semiconductor stack includes a thick N-type region to satisfy the greater than 0.3 to 1 height to width requirement for an effective extraction. One or both of the following two methods may be used to create a thick N-type region in an AlInGaP structure: 1) Grow a thick N-type epitaxial layer using a hydride process, or 2) Remove the growth substrate and attach a transparent wafer using semiconductor wafer bonding as typically practiced for commercial AlInGaP LEDs from Philips Lumileds Lighting. In order to increase extraction of light from the device, the sidewalls 231A and 231B of the completed device are oriented at an angle (or angles) relative to the normal of the light emitting surface i.e. the larger surface of the N-type region 201. Thus the area extent of the top surface 230 is greater than that of the active region 202. The oblique angle need not be constant as a function of device height (as shown in Fig. 2), but may vary continuously according to device height to result in either partially or wholly concave or convex sidewall shapes. The sidewall orientation is optimized such that light rays generated in the plane of the active region land within an escape cone at the top or side surface of the device within a few bounces.

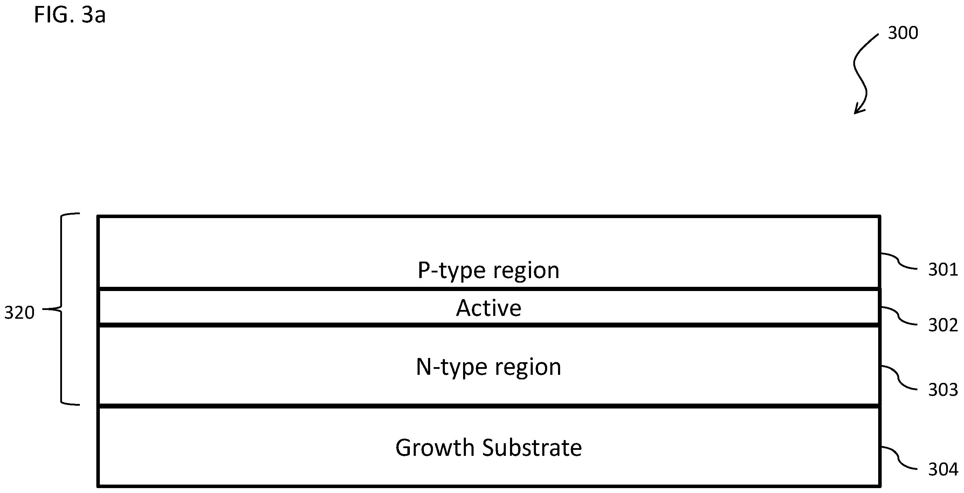

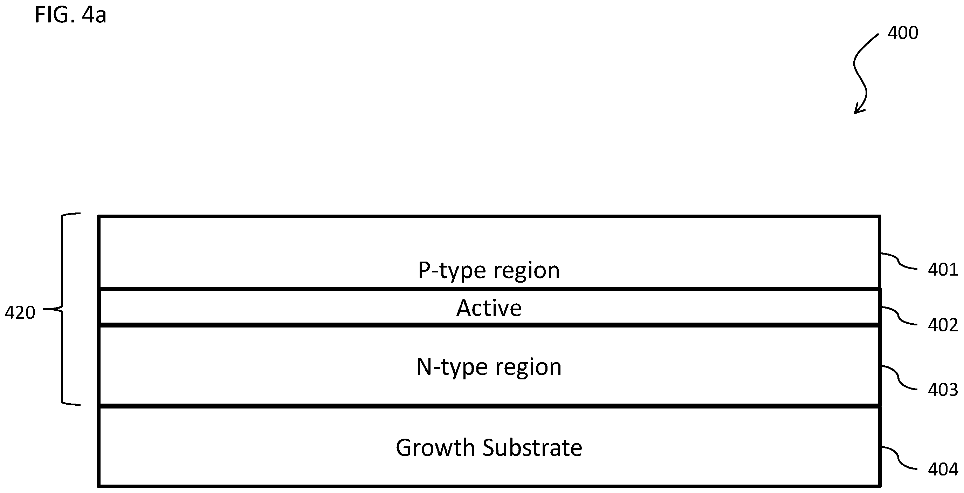

The primary light extraction surfaces of the device are the top surface, (the top surface 230 of P-type region 201, on which P contact 209 is formed, and the four side surfaces of the device 231A, 231B and two other surfaces which are not depicted in Fig. 2. Other shapes are possible including a rectangular solid with vertical sidewalls or a truncated pyramid with sidewalls angled inward. Random or periodic surface texturing on top of P-type region 201 and on the sides of the chip may be added to increase light extraction. In some embodiments, one or more sidewalls of the device are made porous and/or have an ITO/TiAg reflector to further increase light output from the top surface 230. Cylindrical devices, devices with three or more than four sidewalls are contemplated and are included within the scope of the invention. Figs 3a-3g and figs 4a-4e shows an exemplary method for creating a flip chip (FC) device. Although the steps of the method shown here may be used to produce an AlInGaP or InGaN device, any other suitable device type that may be constructed using these methods is contemplated and is included within the scope of the invention.

Although the steps of the process are shown in a particular order other variations such as changing the point in the process when annealing takes place are contemplated and are included within the scope of the invention.

Figs. 3a-3g show an exemplary portion of a wafer of AlInGaP LEDs. Some of the figures show processing of a wafer of LEDs, other show processing applied to one LED or a group of LEDs that have been singulated from the wafer. It is understood that even though one singulated LED or group of LEDs are being processed that the remainder of the LEDs will be similarly processed serially or in parallel.

Fig. 3a is a side view of an exemplary portion of a wafer of AlInGaP LEDs 300. Wafer 300 may be created by growing an AlInGaP epitaxial layer 320 on a growth substrate 304. Epitaxial layer 320 may contain an active region 302 between an N-type region 303 and a P-type region 301. P-type region 301 may be transparent to a wavelength of light emitted by active region 302.

Although Figs. 3a-3g shows the N-type region 303 connected to growth substrate 304, other configurations that reverse the order of the layers such that the P-type region is connected to the substrate 304 are contemplated and are included within the scope of the invention.

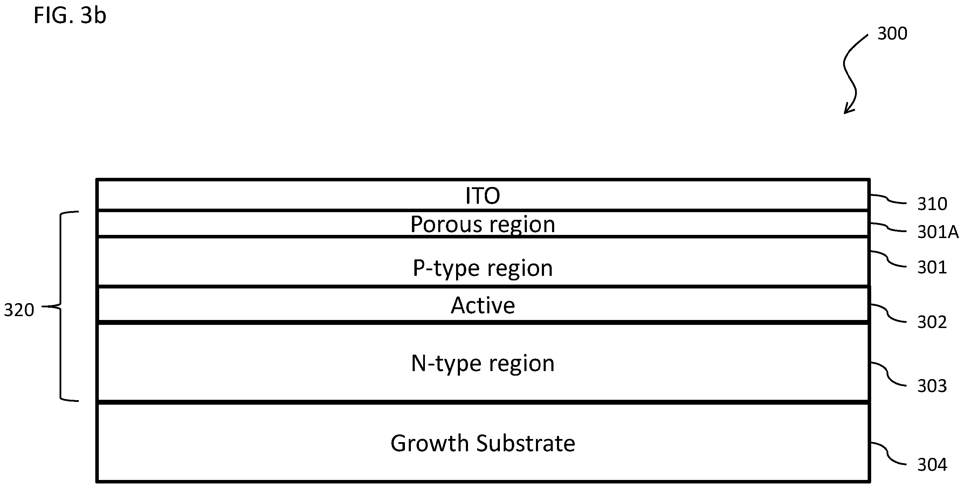

Fig. 3b shows wafer 300 after a portion of P-type region 301 has been converted into porous region 301A an ITO layer 310 has been attached to the porous region 301A. Converting any amount of P-type region 301 to a porous region 301A including a small portion or all of P-type region 301 is contemplated and is included within the scope of the invention. P-type region 301 may be converted in a layer as shown in Fig. 1b or in lateral sections (not shown) where some lateral sections of P-type region 301 remain unconverted. Likewise the porous region 301A may vary in thickness so that some sections are thick and others are thinner.

Next, an ITO region 310 is formed on the porous region 301A. Typically ITO region 310 is formed via an evaporative process and/or a sputtering process. Although ITO is specified any suitable substitute is contemplated but only when ITO is formed, it falls within the scope of the invention.

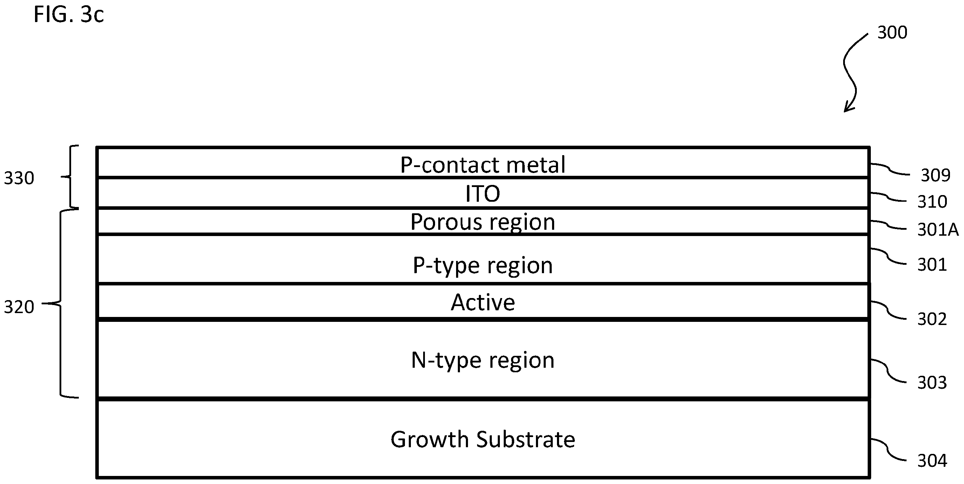

Fig. 3c shows wafer 300 after P-contact 330 has been completed by the deposition of P-contact metal 309 on ITO region 310. Typically a resist is patterned to expose a portion of ITO region 310 followed by a coating of TiAg and a lift-off step to create P-contact metal 309. The TiAg contact may be formed by an evaporative process and/or a sputtering process. Although TiAg is specified any suitable metal such as a TiAu TiAu, CrAu or any other suitable combination/alloy or metal/organic combination is contemplated and is included within the scope of the invention.

As described above with respect to the P-contact 130 Ti may be formed as an adhesion layer. In the alternative, alloys of Ti and Ag or multiple layers in any order may be used as P-contact metal 309.

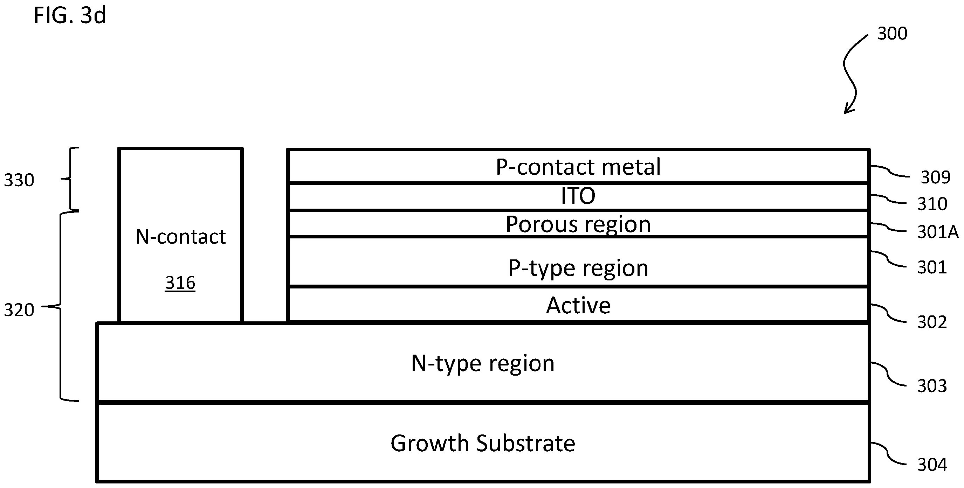

Fig 3d shows wafer 300 after a portion of P-contact metal 309, ITO region 310, porous region 301A, P-type region 301 and active region 302 is etched back to expose a portion of N-type region 303 for the attachment of N-contact 316. In some embodiments a portion of N-type region 303 may also be etched creating an indentation into the N-type region 303. The etch may form voids in the material of P-contact metal ITO region 310, porous region 301A, P-type region 301 and active region 302 of wafer 300. The voids may take the form of trenches, vias or any other suitable shape.

After the etch, N-contact 316 may be formed. N-contact 316 may be formed as a combination of ITO and TiAg. Typically a resist is patterned to expose a portion of the N-type region 303, and ITO is formed via an evaporative process and/or a sputtering process. Although ITO is specified any suitable substitute is contemplated and is included within the scope of the invention. After deposition of ITO, a resist is patterned to expose a portion of the ITO followed by a coating of TiAg and a lift-off step to create N-contact 316. Although TiAg is specified, TiAu, CrAu or any other suitable combination/alloy or metal/organic combination is contemplated and is included within the scope of the invention.

As described above with respect to the P-contact 130 Ti may be formed as an adhesion layer. In the alternative alloys of Ti and Ag or multiple layers in any order may be used to form N-contact 416.

Next, P-contact metal 309 is annealed to P-type region 301. The annealing process completes the mechanical and electrical connection between both contacts; between P-contact metal 309, ITO region 310 and P-type region 301. The annealing process may also anneal N-contact 316 to N-type region 303. Typically annealing requires raising the temperature of wafer to 400 C° for 20 minutes.

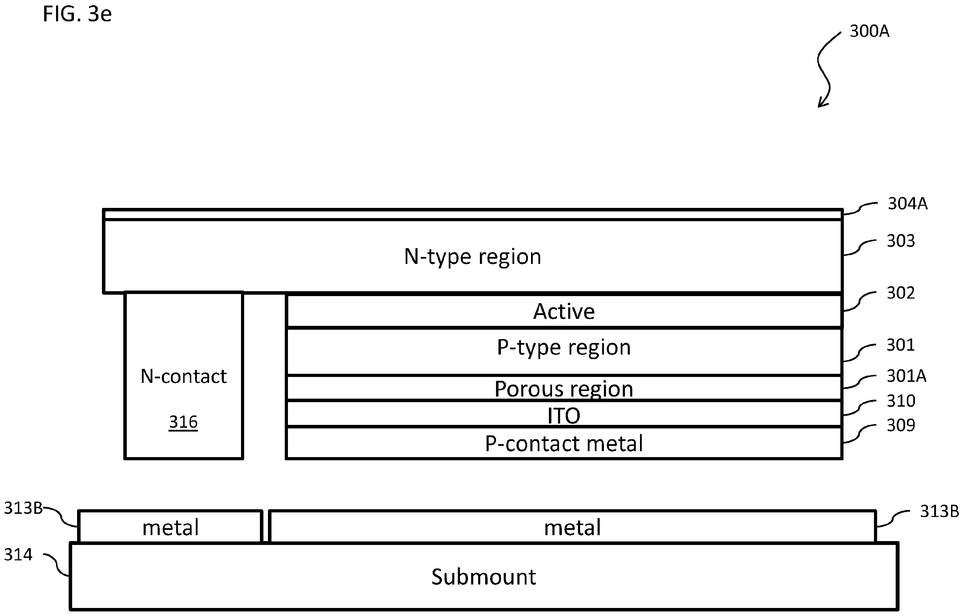

Fig 3e shows a LED 300A which has been singulated from wafer 300. Typically the 304 is removed by a combination of abrasive and chemical processing from wafer 300 prior to singulation. In some embodiments a portion of the growth substrate 304A is retained. Portion of growth substrate 304A may be a layer several microns thick. Portion of growth substrate 304A may be used for current spreading and N-contact formation. For a non-transparent growth substrate such as GaAs, the backside of the wafer may be patterned with resist and growth substrate layer 304 is etched away to create a network of current traces and pads for N-contact formation. In that case the etching of a via for the N-contact would extend to layer 304A.

Next or in parallel a submount 314 with metal contacts 313A and 313B is formed. Metal contacts 313A and 313B correspond to N-contact 316 and P-contact metal 309 respectively. Metal contacts 313A and 313B may be connected to circuits, components or vias contained within and/or on submount 314 including pads on the opposite of side of the submount 314.

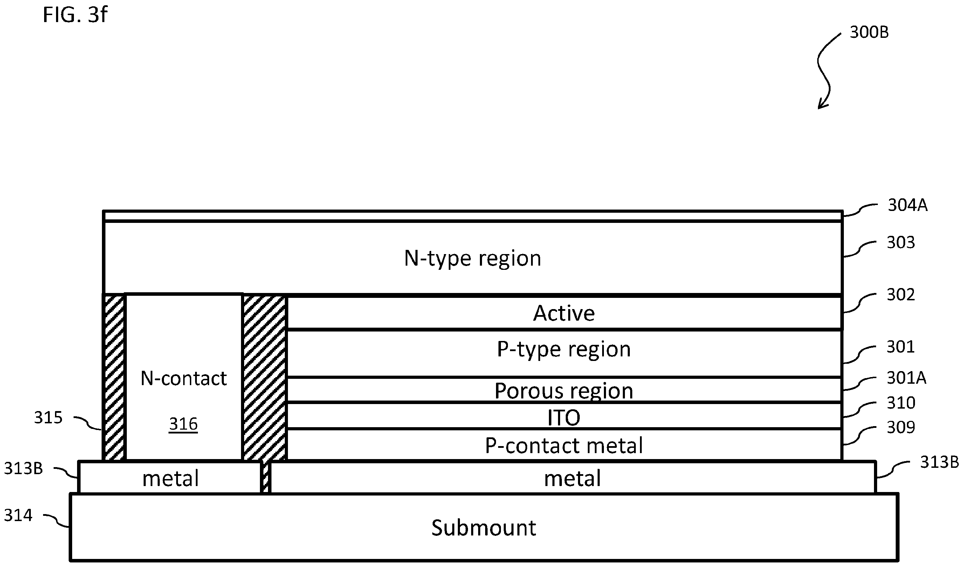

Fig. 3f shows a mounted LED 300B which includes a LED 300A electrically and/or mechanically connected to submount 314. After connecting the LED 300A to submount 314 some or all of the voids between LED 300A and submount 314 are "underfilled" with material 315 as is known in the art. For the sake of clarity the underfill is only shown substantially surrounding N-contact 316. However a typical underfill would be used to substantially fill all voids between the LED 300A and submount 314 including voids near the P-contact metal 309.

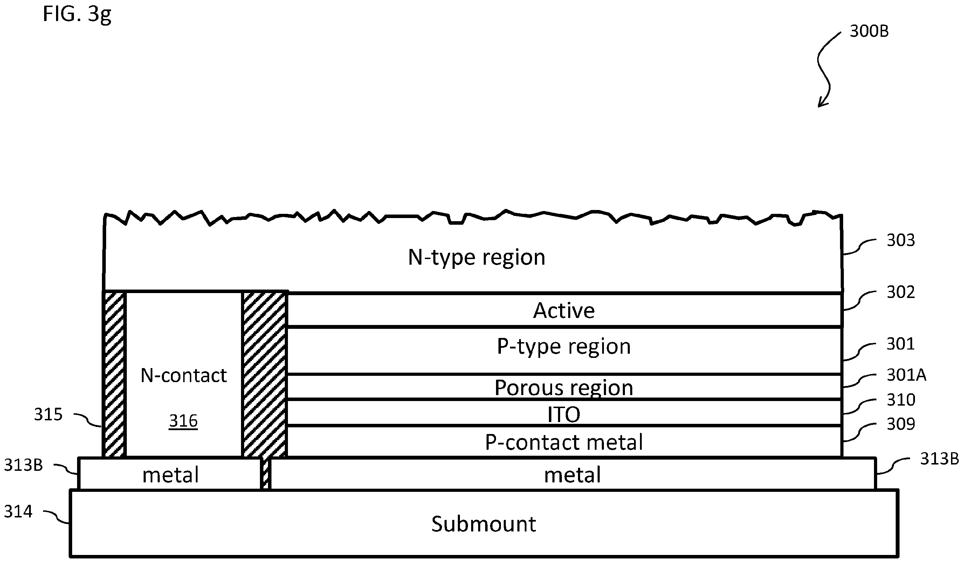

Fig 3g shows a mounted LED 300B after removal of the portion of the growth substrate 304A and roughening of the surface of N-type region 303. In one alternative the small portion of the growth substrate 304A is not removed in another alternative the small portion of the growth substrate 304A is removed but the surface of N-type region 303 is not roughened. Typically most of the portion of the growth substrate 304A is removed, in many cases 90% or more is removed.

Figs. 4a-4e show an exemplary portion of a wafer of InGaN LEDs. Some of the figures show processing of a wafer of LEDs, other show processing applied to one LED or a group of LEDs that have been singulated from the wafer. It is understood that the even though one singulated LED or group of LEDs are being processed that the remainder of the LEDs will be similarly processed serially or in parallel.

Fig. 4a is a side view of an exemplary portion of a wafer of InGaN LEDs 400. Wafer 400 may be created by growing an InGaN epitaxial layer 420 on a growth substrate 404. Epitaxial layer 420 may contain an active region 402 between an N-type region 403 and a P-type region 401. P-type region 401 may be transparent to a wavelength of light emitted by active region 402.

Although Figs. 4a-4e shows the N-type region 403 connected to growth substrate 404, other configurations that reverse the order of the layers such that the P-type region is connected to the substrate 404 are contemplated and are included within the scope of the invention.

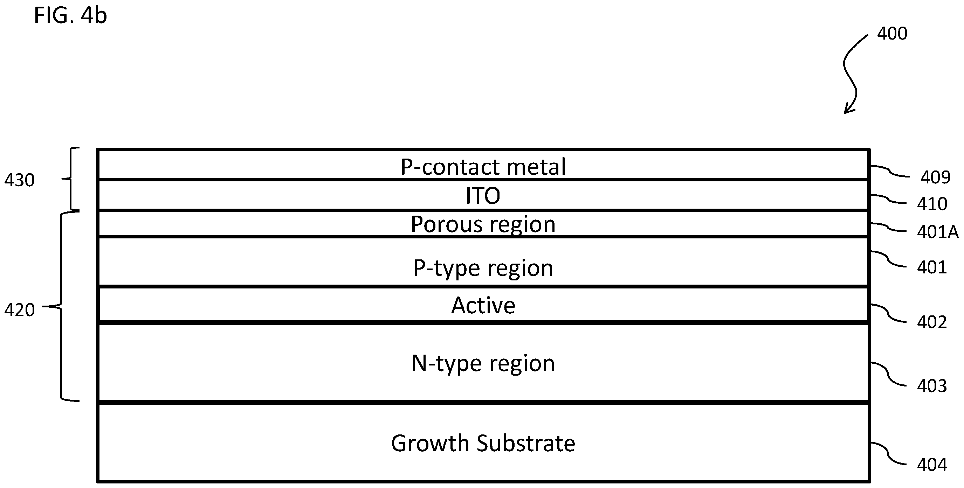

Fig. 4b shows wafer 400 after a portion of P-type region 401 has been converted into porous region 401A and P-contact 430 has been attached to porous region 401A. Converting any amount of P-type region 401 to a porous region 401A including a small portion or all of P-type region 401 is contemplated and is included within the scope of the invention. P-type region 401 may be converted in a layer as shown in Fig. 1b or in lateral sections (not shown) where some lateral sections of P-type region 401 remain unconverted. Likewise the porous region 401A may vary in thickness so that some sections are thick and others are thinner.

Next, an ITO region 410 is formed on the porous region 401A. Typically ITO region 410 is formed via an evaporative process and/or a sputtering process. Although ITO is specified any suitable substitute is contemplated and is included within the scope of the invention.

Next a P-contact metal 409 is created on ITO region 410 to complete the formation of P-contact 430. Typically a resist is patterned to expose a portion of ITO region 410 followed by a coating of Titanium and Silver (TiAg) and a lift-off step to create P-contact metal 409. The TiAg contact may be formed by an evaporative process and/or a sputtering process. Although TiAg is specified any suitable metal such as a TiAu, CrAuor any other suitable combination/alloy or metal/organic combination is contemplated and is included within the scope of the invention.

As described above with respect to the P-contact 130 Ti may be formed as an adhesion layer. In the alternative alloys of Ti and Ag or multiple layers in any order may be used as P-contact metal 109.

After P-contact metal 409 has been created P-contact metal 409 is annealed to P-type region 401. The annealing process completes the mechanical and electrical connection between both contacts; between P-contact metal 409, ITO region 410 and P-type region 401. The annealing process may also anneal N-contact 416 to N-type region 403. Typically annealing requires raising the temperature of wafer to approximately 400 C° for 20 minutes.

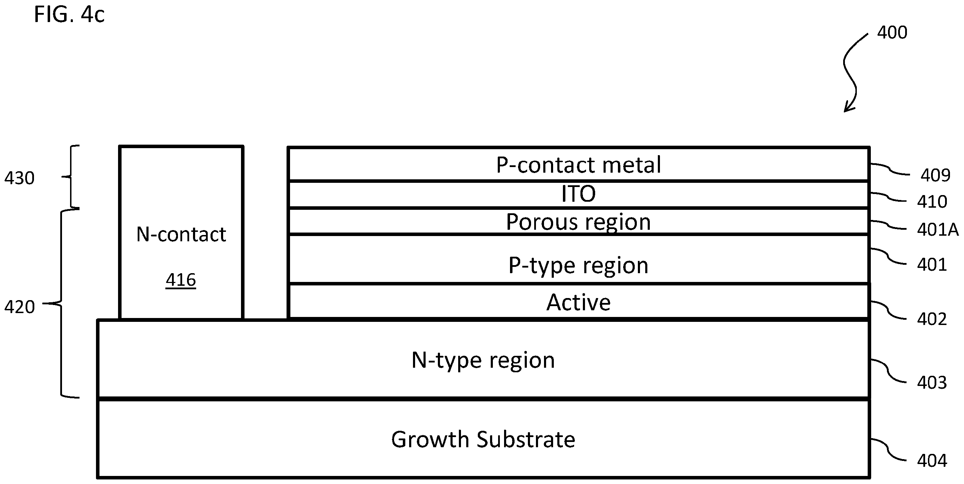

Fig 4c shows wafer 400 after a portion of P-contact metal 409, ITO region 410, porous region 401A, P-type region 401 and active region 402 is etched back to expose a portion of N-type region 403 for the attachment of N-contact 416. Typically, a portion of N-type region 403 may also be etched creating an indentation into the N-type region 403. The etch may form voids in the material of P-contact metal 409, ITO region 410, porous region 4301A, P-type region 401 and active region 402 of wafer 400. A portion of the void may be formed in a portion of N-type region 403. The voids may take the form of trenches, vias or any other suitable shape.

After the etch N-contact 416, N-contact 416 may be formed. Typically the contact metal is Aluminum (Al) and is formed via an evaporative process and/or a sputtering process. Although Al is specified, TiAg, or any other suitable combination/alloy or metal/organic combination is contemplated and is included within the scope of the invention. Typically a resist is patterned together with a lift-off step to create N-contact 416. As described above with respect to the P-contact 130 Ti may be formed as an adhesion layer. In the alternative alloys of Ti and Ag or multiple layers in any order may be used as P-contact metal 109.

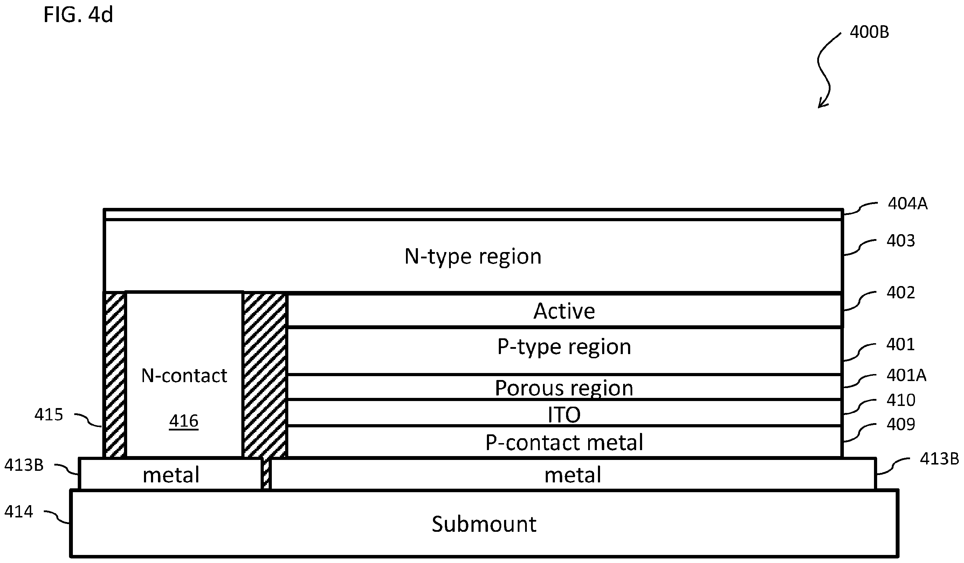

Fig 4d shows a LED 400A which has been singulated from wafer 400. Typically the bulk of growth substrate 404 is removed from wafer 400 prior to singulation. Typically growth substrate 404 is thinned to less than 300 micron by first grinding and and/or lapping leaving a small portion of the growth substrate 404A.

Next or in parallel a submount 414 with metal contacts 413A and 413B is formed. Metal contacts 413A and 413B correspond to N-contact 416 and P-contact metal 409 respectively. Metal contacts 413A and 413B may be connected to circuits, components or vias contained within and/or on submount 414 including pads on the opposite of side of the submount 414.

LED 400A is then electrically and/or mechanically connected to submount 414 to form mounted LED 400B. After connecting the LED 400A to submount 414 some or all of the voids between LED 400A and submount 414 are "underfilled" with material 415 as is known in the art. For the sake of clarity the underfill is only shown substantially surrounding N- 416. However a typical underfill would be used to substantially fill all voids between the LED 400A and submount 414 including voids near the P-contact metal 409 as described above with respect to fig. 3f.

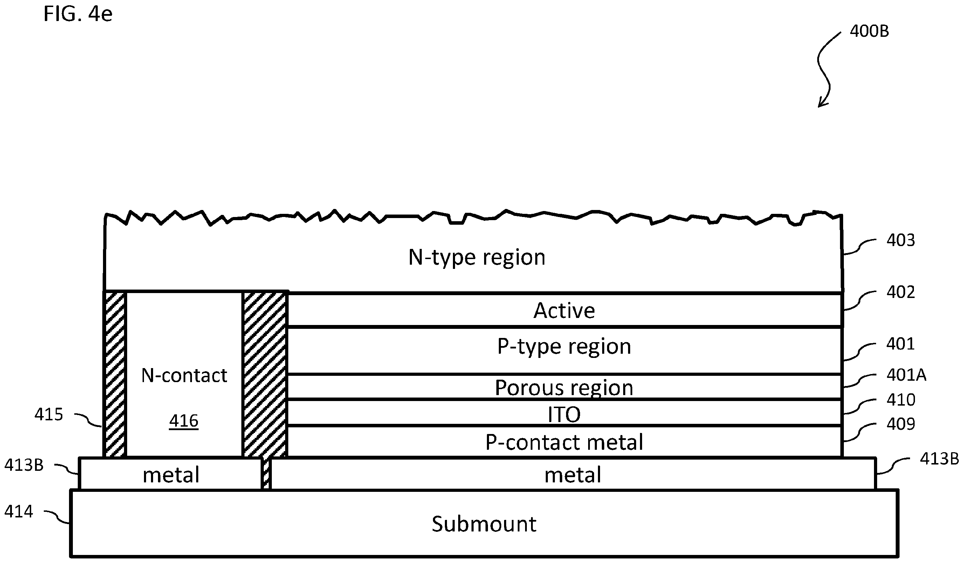

Fig 4e shows a mounted LED 400B after removal of the small portion of the growth substrate 404A and roughening of the surface of N-type region 403. In one alternative the small portion of the growth substrate 404A is not removed in another alternative the small portion of the growth substrate 404A is removed but the surface of N-type region 403 is not roughened. In another embodiment, the epitaxial growth occurs on a non-planar growth substrate and after removal of the growth substrate the surface relief of the growth substrate remains on the surface of 403.

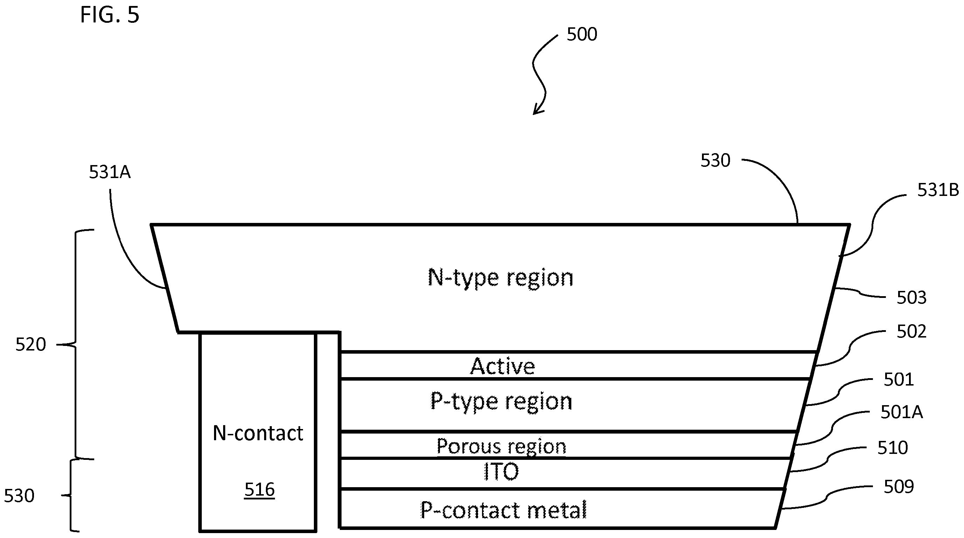

Fig. 5 shows an embodiment of the invention with a similar process flow as Fig. 4 but having non-vertical sidewalls. The semiconductor stack includes a thick N-type region to satisfy the greater than 0.3 to 1 height to width requirement for an effective extraction. For an InGaN device one or both of the following two methods may be used to create a thick N-type region: 1) Grow the epitaxial layers on a transparent, conductive n-type substrate such as bulk GaN or SiC, 2) Grow a thick N-type epitaxial layer using a hydride process. All other design consideration described for Fig. 2 apply to the embodiment shown in Fig. 5.

Although figures 2 and 5 show a porous layer directly connected to contacts, additional porous layers attached to the non-vertical sidewalls are contemplated and are included within the scope of the invention. Although Fig. 5 shows an InGaN shaped chip with thick N-Region in a FC configuration, a VTF form of the device is contemplated and is included within the scope of the invention.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. Any reference signs in the claims should not be construed as limiting the scope.

## Claims

1. A semiconductor structure (100, 200, 300B, 400B, 500), comprising:
a plurality of semiconductor regions (101, 103, 201, 203, 301, 303, 401, 403, 501, 503), comprising a first semiconductor region and a second semiconductor region, wherein one of the semiconductor regions is an N-type region and the other of the semiconductor regions is a P-type region;
a light emitting region (102, 202, 302, 402, 502) disposed between the semiconductor regions (101, 103, 201, 203, 301, 303, 401, 403, 501, 503);
a first surface from which a substantial fraction of the light extracted from the semiconductor structure is emitted; a second surface opposite to the first surface;
a first contact (109, 209, 309, 409, 509) electrically connected to one of the semiconductor regions, the first contact comprising:
a metallic region (107, 207, 309, 313B, 409, 413B, 509);
a first porous region (103A, 203A, 301A, 401A, 501A) disposed between the first contact and the light emitting region; and
a second contact (109, 316, 416, 516) electrically connected to one of the semiconductor regions;
wherein the first contact (109, 209, 309, 409, 509) and the second contact (109, 316, 416, 516) are connected to different semiconductor regions (101, 103, 201, 203, 301, 303, 401, 403, 501, 503),
wherein the light emitting region (102, 202, 302, 402, 502) is disposed between the first surface and the first porous region (103A, 203A, 301A, 401A, 501A),
**characterized in that**, the first contact (109, 209, 309, 409, 509) is further comprising a first ITO region (310) disposed between the first porous region (103A, 203A, 301A, 401A, 501A) and the metallic region (107, 207, 309, 313B, 409, 413B, 509) of the first contact (109, 209, 309, 409, 509).

2. The device of claim 1, wherein a portion of the first semiconductor region (101, .., 301, ...) and light emitting layer (302) are removed to expose a third surface of the second semiconductor region and the second contact (316) is disposed on the third surface.

3. The device of claim 1 further comprising a matched substrate (108) disposed on one of the first contact (309) and the second contact (316).

4. The device of claim 1 further comprising a growth substrate (304A), wherein one of the semiconductor regions (301, 303) is disposed on the growth substrate.

5. The device of Claim 4 where the growth substrate (304A) is one of GaN, SiC or sapphire.

6. The device of Claim 4 wherein the semiconductor region disposed on the growth substrate (304A) is the second semiconductor region (303) and the first surface is the surface of the growth substrate (304A) opposite to the second semiconducting region (303).

7. The device of Claim 6 where the growth substrate (304A) is conductive GaN and the second contact is formed on the first surface.

8. The device of Claim 4 where the growth substrate (304A) is removed and a transparent window semiconductor has been bonded to the second region, the first surface of the semiconductor structure being opposite to the bonded interface of the transparent window semiconductor.

9. The device of claim 1 wherein the first contact (309) is electrically connected to the P-type region and the first porous region (301A) is disposed between the P-type region (301) and the first contact (309).

10. The device of claim 1 wherein the first contact is electrically connected to the N-type region and the first porous region is disposed between the N-type region and the first contact.

11. The device of claim 10 further comprising a second contact electrically connected to the P-type region.

12. The device of claim 9 further comprising a second contact (316) electrically connected to the N-type region (303).

13. The device of claim 1, wherein one (309) of the first and second contacts is disposed on the second surface of the semiconductor structure and the other (316) of the first and second contacts is disposed in a void formed in the semiconductor structure.

14. The device of claim 1 wherein a side surface of the semiconductor structure (300B) is substantially perpendicular to the first surface of the semiconductor structure (300B).

15. The device of claim 1 wherein a side surface (231A, 231B) of the semiconductor structure (300B) is oblique to the first surface of the semiconductor structure (300B).

16. The device of claim 1 wherein a side surface of the semiconductor structure (300B) is the surface of a second porous region.

17. The device of claim 1 wherein the metallic region (313B) comprises silver.

18. The device of claim 1 wherein the first porous region (301A) has a thickness between 0.4 and 40 microns.

19. The device of claim 1 wherein the first ITO region (310) has a thickness is between 200nm and 400nm.

20. The device of claim 1 wherein the first porous region (301A) has a porosity between 5% and 80%, wherein the porosity is the percent volume of air in the first porous region.

21. The device of claim 1 wherein the first porous region (301A) has a porosity between 20% and 40%, wherein the porosity is the percent volume of air in the first porous region.

22. The device of claim 1 wherein the first porous region comprises a semiconducting alloy of composition AlₓIn_{y}Ga_{z}As_{α}P_{1-α} where 0≥x, y, z, α ≤1, and x+y+z=1 or In_{β}Ga_{1-β}N where 0≥β ≤0.2.

23. The device of claim 1 wherein the first porous region (301A) is arranged such that all light emitted from the light emitting layer (302) in the direction of the first contact (309) strikes the first porous region (301A) before striking the first contact (309).

## Patentansprüche

1. Halbleiterstruktur (100, 200, 300B, 400B, 500), umfassend:
eine Mehrzahl von Halbleiterregionen (101, 103, 201, 203, 301, 303, 401, 403, 501, 503), die eine erste Halbleiterregion und eine zweite Halbleiterregion umfassen, wobei eine der Halbleiterregionen eine n-leitende Region ist, und die andere der Halbleiterregionen eine p-leitende Region ist;
eine Licht emittierende Region (102, 202, 302, 402, 502), die zwischen den Halbleiterregionen (101, 103, 201, 203, 301, 303, 401, 403, 501, 503) angeordnet ist;
eine erste Oberfläche, von welcher ein wesentlicher Teil des aus der Halbleiterstruktur extrahierten Lichts emittiert wird;
eine zweite Oberfläche gegenüber der ersten Oberfläche;
einen ersten Kontakt (109, 209, 309, 409, 509), der mit einer der Halbleiterregionen elektrisch verbunden ist, wobei der erste Kontakt umfasst:
eine metallische Region (107, 207, 309, 313B, 409, 413B, 509); eine erste poröse Region (103A, 203A, 301A, 401A, 501A), die zwischen dem ersten Kontakt und der Licht emittierenden Region angeordnet ist; und
einen zweiten Kontakt (109, 316, 416, 516, 509), der mit einer der Halbleiterregionen elektrisch verbunden ist;
wobei der erste Kontakt (109, 209, 309, 409, 509) und der zweite Kontakt (109, 316, 416, 516) mit verschiedenen Halbleiterregionen (101, 103, 201, 203, 301, 303, 401, 403, 501, 503) verbunden sind,
wobei die Licht emittierende Region (102, 202, 302, 402, 502) zwischen der ersten Oberfläche und der ersten porösen Region (103A, 203A, 301A, 401A, 501A) angeordnet ist,
**dadurch gekennzeichnet, dass**
der erste Kontakt (109, 209, 309, 409, 509) ferner eine erste ITO-Region (310) umfasst, die zwischen der ersten porösen Region (103A, 203A, 301A, 401A, 501A) und der metallischen Region (107, 207, 309, 313B, 409, 413B, 509) des ersten Kontakts (109, 209, 309, 409, 509) angeordnet ist.

2. Vorrichtung nach Anspruch 1, wobei ein Abschnitt der ersten Halbleiterregion (101, ..., 301, ...) und der Licht emittierenden Schicht (302) entfernt ist, um eine dritte Oberfläche der zweiten Halbleiterregion freizulegen, und der zweite Kontakt (316) auf der dritten Oberfläche angeordnet ist.

3. Vorrichtung nach Anspruch 1, ferner umfassend ein angepasstes Substrat (108), das auf einem von dem ersten Kontakt (309) und dem zweiten Kontakt (316) angeordnet ist.

4. Vorrichtung nach Anspruch 1, ferner umfassend ein Wachstumssubstrat (304A), wobei eine der Halbleiterregionen (301, 303) auf dem Wachstumssubstrat angeordnet ist.

5. Vorrichtung nach Anspruch 4, wobei das Wachstumssubstrat (304A) eines von GaN, SiC oder Saphir ist.

6. Vorrichtung nach Anspruch 4, wobei die Halbleiterregion, die auf dem Wachstumssubstrat (304A) angeordnet ist, die zweite Halbleiterregion (303) ist, und die erste Oberfläche die Oberfläche des Wachstumssubstrats (304A) gegenüber der zweiten Halbleiterregion (303) ist.

7. Vorrichtung nach Anspruch 6, wobei das Wachstumssubstrat (304A) leitendes GaN ist, und der zweite Kontakt auf der ersten Oberfläche ausgebildet ist.

8. Vorrichtung nach Anspruch 4, wobei das Wachstumssubstrat (304A) entfernt ist, und ein transparenter Fensterhalbleiter an die zweite Region gebondet wurde, wobei die erste Oberfläche der Halbleiterstruktur gegenüber der gebondeten Berührungsfläche des transparenten Fensterhalbleiters ist.

9. Vorrichtung nach Anspruch 1, wobei der erste Kontakt (309) mit der p-leitenden Region elektrisch verbunden ist, und die erste poröse Region (301A) zwischen der p-leitenden Region (301) und dem ersten Kontakt (309) angeordnet ist.

10. Vorrichtung nach Anspruch 1, wobei der erste Kontakt mit der n-leitenden Region elektrisch verbunden ist, und die erste poröse Region zwischen der n-leitenden Region und dem ersten Kontakt angeordnet ist.

11. Vorrichtung nach Anspruch 10, ferner umfassend einen zweiten Kontakt, der mit der p-leitenden Region elektrisch verbunden ist.

12. Vorrichtung nach Anspruch 9, ferner umfassend einen zweiten Kontakt (316), der mit der n-leitenden Region (303) elektrisch verbunden ist.

13. Vorrichtung nach Anspruch 1, wobei einer (309) der ersten und zweiten Kontakte auf der zweiten Oberfläche der Halbleiterstruktur angeordnet ist, und der andere (316) der ersten und zweiten Kontakte in einem Hohlraum angeordnet ist, der in der Halbleiterstruktur ausgebildet ist.

14. Vorrichtung nach Anspruch 1, wobei eine Seitenfläche der Halbleiterstruktur (300B) im Wesentlichen senkrecht auf die erste Oberfläche der Halbleitersturkur (300B) ist.

15. Vorrichtung nach Anspruch 1, wobei eine Seitenfläche (231A, 231B) der Halbleiterstruktur (300B) schräg zur ersten Oberfläche der Halbleiterstruktur (300B) ist.

16. Vorrichtung nach Anspruch 1, wobei eine Seitenfläche der Halbleiterstruktur (300B) die Oberfläche einer zweiten porösen Region ist.

17. Vorrichtung nach Anspruch 1, wobei die metallische Region (313B) Silber umfasst.

18. Verfahren nach Anspruch 1, wobei die erste poröse Region (301A) eine Dicke von 0,4 bis 40 Mikrometer aufweist.

19. Verfahren nach Anspruch 1, wobei die erste ITO-Region (310) eine Dicke von 200 nm bis 400 nm aufweist.

20. Vorrichtung nach Anspruch 1, wobei die erste poröse Region (301A) eine Porosität von 5 % bis 80 % aufweist, wobei die Porosität das Volumenprozent von Luft in der ersten porösen Region ist.

21. Vorrichtung nach Anspruch 1, wobei die erste poröse Region (301A) eine Porosität von 20 % bis 40 % aufweist, wobei die Porosität das Volumenprozent von Luft in der ersten porösen Region ist.

22. Vorrichtung nach Anspruch 1, wobei die erste poröse Region eine halbleitende Legierung der Zusammensetzung AlₓIn_{y}Ga_{z}As_{α}P_{1-α}, wobei 0 ≤ x, y, z, a ≥ 1 und x + y + z = 1, oder In_{β}Ga_{1-β}N, wobei 0 ≤ β ≥ 0,2, umfasst.

23. Vorrichtung nach Anspruch 1, wobei die erste poröse Region (301A) derart angeordnet ist, dass das gesamte Licht, das von der Licht emittierenden Schicht (302) in der Richtung des ersten Kontakts (309) emittiert wird, auf die erste poröse Region (301A) auftrifft, bevor es auf den ersten Kontakt (309) auftrifft.

## Revendications

1. Structure semi-conductrice (100, 200, 300B, 400B, 500), comprenant :
une pluralité de régions semi-conductrices (101, 103, 201, 203, 301, 303, 401, 403, 501, 503), comprenant une première région semi-conductrice et une deuxième région semi-conductrice, dans laquelle l'une des régions semi-conductrices est une région de type N et l'autre des régions semi-conductrices est une région de type P ;
une région d'émission de lumière (102, 202, 302, 402, 502) disposée entre les régions semi-conductrices (101, 103, 201, 203, 301, 303, 401, 403, 501, 503) ;
une première surface à partir de laquelle une fraction importante de la lumière extraite de la structure semi-conductrice est émise ;
une deuxième surface opposée à la première surface ;
un premier contact (109, 209, 309, 409, 509) connecté électriquement à l'une des régions semi-conductrices, le premier contact comprenant :
une région métallique (107, 207, 309, 313B, 409, 413B, 509) ;
une première région poreuse (103A, 203A, 301A, 401A, 501A) disposée entre le premier contact et la région d'émission de lumière ; et
un deuxième contact (109, 316, 416, 516) connecté électriquement à l'une des régions semi-conductrices ;
dans laquelle le premier contact (109, 209, 309, 409, 509) et le deuxième contact (109, 316, 416, 516) sont connectés à différentes régions semi-conductrices (101, 103, 201, 203, 301, 303, 401, 403, 501, 503),
dans laquelle la région d'émission de lumière (102, 202, 302, 402, 502) est disposée entre la première surface et la première région poreuse (103A, 203A, 301A, 401A, 501A),
**caractérisée en ce que**
le premier contact (109, 209, 309, 409, 509) comprend en outre une première région d'ITO (310) disposée entre la première région poreuse (103A, 203A, 301A, 401A, 501A) et la région métallique (107, 207, 309, 313B, 409, 413B, 509) du premier contact (109, 209, 309, 409, 509).

2. Dispositif selon la revendication 1, dans lequel une partie de la première région semi-conductrice (101, ..., 301, ...) et la couche d'émission de lumière (302) sont retirées pour exposer une troisième surface de la deuxième région semi-conductrice et le deuxième contact (316) est disposé sur la troisième surface.

3. Dispositif selon la revendication 1, comprenant en outre un substrat correspondant (108) disposé sur l'un du premier contact (309) et du deuxième contact (316).

4. Dispositif selon la revendication 1, comprenant en outre un substrat de croissance (304A), dans lequel l'une des régions semi-conductrices (301, 303) est disposée sur le substrat de croissance.

5. Dispositif selon la revendication 4, dans lequel le substrat de croissance (304A) est l'un du GaN, du SiC ou du saphir.

6. Dispositif selon la revendication 4, dans lequel la région semi-conductrice disposée sur le substrat de croissance (304A) est la deuxième région semi-conductrice (303) et la première surface est la surface du substrat de croissance (304A) opposée à la deuxième région semi-conductrice (303).

7. Dispositif selon la revendication 6, où le substrat de croissance (304A) est du GaN conducteur et le deuxième contact est formé sur la première surface.

8. Dispositif selon la revendication 4, où le substrat de croissance (304A) est retiré et un semi-conducteur de fenêtre transparente a été lié à la deuxième région, la première surface de la structure semi-conductrice étant opposée à l'interface liée du semi-conducteur de fenêtre transparente.

9. Dispositif selon la revendication 1, dans lequel le premier contact (309) est connecté électriquement à la région de type P et la première région poreuse (301A) est disposée entre la région de type P (301) et le premier contact (309).

10. Dispositif selon la revendication 1, dans lequel le premier contact est connecté électriquement à la région de type N et la première région poreuse est disposée entre la région de type N et le premier contact.

11. Dispositif selon la revendication 10, comprenant en outre un deuxième contact connecté électriquement à la région de type P.

12. Dispositif selon la revendication 9, comprenant en outre un deuxième contact (316) connecté électriquement à la région de type N (303).

13. Dispositif selon la revendication 1, dans lequel l'un (309) des premier et deuxième contacts est disposé sur la deuxième surface de la structure semi-conductrice et l'autre (316) des premier et deuxième contacts est disposé dans un vide formé dans la structure semi-conductrice.

14. Dispositif selon la revendication 1, dans lequel une surface latérale de la structure semi-conductrice (300B) est sensiblement perpendiculaire à la première surface de la structure semi-conductrice (300B).

15. Dispositif selon la revendication 1, dans lequel une surface latérale (231A, 231B) de la structure semi-conductrice (300B) est oblique par rapport à la première surface de la structure semi-conductrice (300B).

16. Dispositif selon la revendication 1, dans lequel une surface latérale de la structure semi-conductrice (300B) est la surface d'une deuxième région poreuse.

17. Dispositif selon la revendication 1, dans lequel la région métallique (313B) comprend de l'argent.

18. Dispositif selon la revendication 1, dans lequel la première région poreuse (301A) a une épaisseur entre 0,4 et 40 microns.

19. Dispositif selon la revendication 1, dans lequel la première région d'ITO (310) a une épaisseur entre 200 nm et 400 nm.

20. Dispositif selon la revendication 1, dans lequel la première région poreuse (301A) a une porosité entre 5 % et 80 %, dans lequel la porosité est le volume d'air en pour cent dans la première région poreuse.

21. Dispositif selon la revendication 1, dans lequel la première région poreuse (301A) a une porosité entre 20 % et 40 %, dans lequel la porosité est le volume d'air en pour cent dans la première région poreuse.

22. Dispositif selon la revendication 1, dans lequel la première région poreuse comprend un alliage semi-conducteur de composition AlₓIn_{y}Ga_{z}As_{α}P_{1-α} où 0 ≥ x, y, z, α ≤ 1, et x + y + z = 1 ou In_{β}Ga_{1-β}N où 0 ≥ β ≤ 0,2.

23. Dispositif selon la revendication 1, dans lequel la première région poreuse (301A) est agencée de sorte que toute la lumière émise à partir de la couche d'émission de lumière (302) dans la direction du premier contact (309) frappe la première région poreuse (301A) avant de frapper le premier contact (309).
